# EUROPÄISCHE PATENTANMELDUNG

(11) **EP 1 030 359 A2**
(43) Veröffentlichungstag der Anmeldung: **23.08.2000**
(21) Anmeldenummer: 99125339.4
(22) Anmeldetag: 20.12.1999
(51) Int. Cl.: H01L 21/60, H01L 23/485

(54) **Schichtanordnung sowie Verfahren zu deren Herstellung**

(30) Priorität: 19.02.1999 DE 19907168
(71) Anmelder: Micronas GmbH, 79108 Freiburg (DE)
(72) Erfinder: Igel, Günter Dipl.-Ing., 79331 Teningen (DE); Gahle, Jürgen Dr. Ing., 79312 Emmendingen (DE); Lehmann, Mirko Dipl. Phys., 79106 Freiburg i.Br. (DE)
(74) Vertreter: Schmitt, Hans, Dipl.-Ing.

(57) **Zusammenfassung**

Bei einem Verfahren zum Herstellen einer einen Bump für eine Flip-Chip- oder dergleichen Verbindung aufweisenden Schichtanordnung (1) werden mehrere Schichten (2, 3, 4, 5, 6, 7, 11) aus Festkörpermaterial zu einem Schichtstapel (8) geschichtet. In den Schichtstapel (8) wird quer zu den Schichtungsebenen der Schichten (2, 3, 4, 5, 6, 7, 11) eine sich über mehrere der Schichten (2, 3, 4, 5, 6, 7, 11) erstreckende Ausnehmung (10) eingebracht. In die Ausnehmung (10) wird ein Bump-Material (14) eingebracht. An der seitlichen Begrenzungswand der Ausnehmung (10) durch Abtragen von Schichtmaterial unterschiedlicher Schichten (2, 3, 4, 5, 6, 7, 11) des Schichtstapels (8) eine Profilierung erzeugt wird, die ausgehend von der Oberfläche (9) des Schichtstapels (8) zum Inneren der Ausnehmung (10) hin schichtweise wenigstens zwei Rücksprünge (12) und zumindest einen dazwischen befindlichen Vorsprung (13) aufweist. Nach dem Fertigstellen der Profilierung wird ein Bump-Material (14) in die Ausnehmung (10) eingebracht, das die Rücksprünge (12) hintergreift.

## Beschreibung

Die Erfindung bezieht sich auf ein Verfahren zum Herstellen einer wenigstens einen Bump aufweisenden Schichtanordnung, insbesondere für eine Flip-Chip- oder dergleichen Verbindung, wobei mehrere Schichten aus Festkörpermaterial zu einem Schichtstapel geschichtet werden, in den quer zu den Schichtungsebenen der Schichten wenigstens eine Ausnehmung eingebracht wird, in die ein Bump-Material derart eingefüllt oder eingebracht wird. Außerdem betrifft die Erfindung eine Schichtanordnung mit einem mehrere Schichten aus Festkörpermaterial aufweisenden Schichtstapel, der eine sich quer zu den Schichtungsebenen der Schichten erstreckende Ausnehmung hat, in der ein insbesondere für eine Flip-Chip- oder dergleichen Verbindung vorgesehener Bump angeordnet ist, der einen an der Oberfläche des Schichtstapels vorstehenden Überstand aufweist, wobei der Bump aus einem durchgehend einstückigen Bump-Material besteht.

Ein solches Verfahren und eine danach hergestellte Schichtanordnung sind bereits aus dem Buch Flip Chip Technologies, John H. Lau, McGraw-Hill (1996) bekannt. Dabei wird auf einen Teilbereich der Oberfläche eines aus einem Halbleiter-Material bestehenden Substrat zunächst bereichsweise eine als Anschlußpad dienende Aluminium-Schicht aufgebracht. Danach wird das Substrat mit einer Passivierungsschicht beschichtet, welche die Aluminium-Schicht und den daran angrenzenden Oberflächenbereich des Substrats überdeckt. Zum Freilegen der Aluminium-Schicht wird dann eine Ausnehmung in die Passivierungsschicht eingebracht. Auf die Aluminium-Schicht und die seitlich daran angrenzenden Bereiche der Passivierungsschicht werden Haftschichten aufgebracht, welche das Anhaften weiterer darauf aufzubringender Schichten und des in die Ausnehmung einzubringenden Bump-Materials verbessern sollen. Auf die Haftschichten werden dann eine Kupfer-Schicht, die das Eindringen von Feuchtigkeit in den Schichtstapel erschweren soll und eine Gold-Schicht aufgetragen, die als Oxydationsbarriere dient. Anschließend wird in die Ausnehmung das Bump-Material eingebracht, beispielsweise durch Aufdampfen durch eine Metallmaske hindurch, durch Platieren, Dispergieren oder Bedrucken.

Zwar wird durch die zwischen dem Substrat und dem Bump-Material befindlichen Haftschichten in gewissem Umfang ein besseres Anhaften des Bumps an das Substrat erreicht, jedoch ist die mechanische Festigkeit der nach dem Verfahren hergestellten Schichtanordnung dennoch verbesserungswürdig. In der Praxis hat sich außerdem die Feuchtigkeitsbeständigkeit der Schichtanordnung als problematisch erwiesen, da Feuchtigkeit das Bump-Material unterkriechen und an dem Bump-Material und/oder den Schichten des Schichtstapels Korrosion verursachen kann. Dadurch wird einerseits die mechanische Festigkeit der Schichtanordnung geschwächt und andererseits kann die Feuchtigkeit aber auch die elektrischen Eigenschaften der Schichtanordnung verändern. Insbesondere besteht bei einem als elektrischer Anschlußkontakt dienender Bump die Gefahr, daß die Feuchtigkeit elektrische Kriechströme oder Kurzschlüsse verursacht.

Es besteht deshalb die Aufgabe, eine Schichtanordnung der eingangs genannten Art zu schaffen, bei welcher der Bump mechanisch gut an den Schichten des Schichtstapels anhaftet. Bei einem aus elektrisch leitfähigem Material bestehenden Bump soll die Schichtanordnung außerdem einen kleinen elektrischen Widerstand zwischen dem Bump und den Schichten ermöglichen. Außerdem besteht die Aufgabe, ein Verfahren zum Herstellen einer solchen Schichtanordnung anzugeben.

Diese Aufgabe wird bezüglich des Verfahrens dadurch gelöst, daß in den Schichtstapel eine sich über mehrere seiner Schichten erstreckende Ausnehmung eingebracht wird, daß an der seitlichen Begrenzungswand der Ausnehmung durch Abtragen von Schichtmaterial unterschiedlicher Schichten des Schichtstapels eine Profilierung erzeugt wird, die ausgehend von der an die Ausnehmung angrenzenden Oberfläche des Schichtstapels zum Inneren der Ausnehmung hin schichtweise wenigstens zwei Rücksprünge und zumindest einen dazwischen befindlichen Vorsprung aufweist und daß das Bump-Material nach dem Fertigstellen der Profilierung derart in die Ausnehmung eingebracht wird, daß es die Rücksprünge hintergreift.

Die Begrenzungswand der Ausnehmung wird also durch schichtweises Abtragen von Schichtmaterial mit einer Profilierung versehen und das Bump-Material wird so in die Ausnehmung eingebracht, daß es in die Profilierung beziehungsweise die jeweils zwischen zueinander benachbarten Profilierungsvor- und Rücksprüngen gebildeten Freiräume eingreift. In vorteilhafter Weise ergibt sich dadurch eine formschlüssige Verbindung zwischen dem Bump und dem Schichtstapel, wobei seitliche Vorsprünge des Bumps die Rücksprünge der Begrenzungswand des Schichtstapels hintergreifen. Das Bump-Material greift also kammartig in die Profilierung der durch den Schichtstapel gebildeten Begrenzungswand der Ausnehmung ein, wodurch ein gutes Anhaften des Bumps an den Schichtstapels und somit eine entsprechend große Festigkeit der Verbindung zwischen dem Bump und dem Schichtstapel erreicht wird. Zweckmäßigerweise wird das Bump-Material vollständig in die Ausnehmung eingebracht, so daß sich ein durchgehend einstückiger, mechanisch stabiler Bump ergibt, der makroskopisch betrachtet homogen und frei von Grenzflächen ist. Mikrospkopisch betrachtet kann das Bump-Material Inhomogenitäten aufweisen, z.B. wenn das Bump-Material aus einer elastischen Kunststoffmasse besteht,in die Metall- oder dergleichen Festkörperpartikel eingeschlossen sind.
Durch die sich durch die in die Begrenzungswand eingebrachten Vor- und Rücksprünge der Profilierung ergebende Verzahnung zwischen dem Schichtstapel und dem Bump-Material wird außerdem eine gute Feuchtigkeitsbeständigkeit der Schichtanordnung erreicht. Insbesondere wird die Gefahr vermindert, daß Feuchtigkeit von der Oberfläche der Schichtanordnung entlang der die Grenzfläche zwischen dem Schichtstapel und dem Bump bildenden Oberfläche der Begrenzungswand der Ausnehmung zur Rückseite des Bumps gelangt und dort Korrosion verursacht.

Die Schichten der Schichtanordnung können beispielsweise durch Bedampfen, durch eine chemische Reaktion an der Oberfläche des Schichtstapels, insbesondere durch Oxydation von Schichtmaterial, durch galvanisches Abscheiden von Schichtmaterial oder andere aus der Planartechnik an sich bekannte Beschichtungsverfahren hergestellt werden. Dadurch kann eine gute mechanische Verbindung zwischen den jeweils benachbart aneinander angrenzenden Schichten des Schichtstapels erreicht werden.

Da das Bump-Material erst nach Fertigstellung der Schichtanordnung in die Ausnehmung eingebracht wird, ermöglicht das Verfahren außerdem eine einfache Herstellung der Schichtanordnung. Insbesondere kann die Ausnehmung in einem Arbeitsgang in mehrere oder sogar sämtliche Schichten des Schichtstapels eingebracht werden, beispielsweise durch einen Ätzprozeß. Beim Einbringen des Bumps in den Schichtstapel kann somit ein Eingriff in den Fertigungsprozeß des Schichtstapels vermieden werden.

Eine besonders vorteilhafte Ausführungsform der Erfindung sieht vor, daß ein flüssiges oder fließfähiges Bump-Material in die Ausnehmung eingebracht und anschließend verfestigt wird, insbesondere durch Erstarren, Aushärten, und/oder durch Trocknen eines in dem Bump-Material enthaltenen Lösungsmittels. Das Bump-Material kann dadurch auf einfache Weise in die Ausnehmung eingefüllt werden, wobei auch im Bereich der jeweils zwischen zueinander benachbarten Rücksprüngen und Vorsprüngen der Begrenzungswand gebildeten Freiräume bzw. Aussparungen eine vollständige Befüllung und somit eine gute formschlüssige Verbindung des Bumps mit dem Schichtstapel erreicht werden kann. Das flüssige oder fließfähige Bump-Material kann beispielsweise durch Bedrucken des Schichtstapels in die Ausnehmung eingebracht werden, insbesondere mittels Siebdrucktechnik. Dadurch kann das Bump-Material auf einfache Weise in eine Vielzahl von in dem Schichtstapel befindlichen Ausnehmungen gleichzeitig eingefüllt werden.

Eine andere Ausführungsform der Erfindung sieht vor, daß das Bump-Material auf die seitliche Begrenzungswand und/oder den Boden der Ausnehmung aufgalvanisiert wird. Das Bump-Material kann dann besonders gut in den Bereich der Rücksprünge der Begrenzungswand der Ausnehmung gelangen. Das Aufgalvanisieren des Bump-Materials kann stromlos oder mittels eines externen elektrischen Feldes erfolgen.

Eine bevorzugte, besonders vorteilhafte Ausführungsform der Erfindung sieht vor, daß der Schichtstapel zum Einbringen der Ausnehmung mit einem Ätzmittel in Berührung gebracht wird und daß die Schichtmaterialien der einzelnen Schichten zum Einformen der Profilierung in die Begrenzungswand der Ausnehmung so ausgewählt werden, daß sie bezüglich des Ätzmittels unterschiedliche Ätzraten aufweisen. Mittels des Ätzmittels können sämtliche Schichten des Schichtstapels auf einfache Weise in einem Arbeitsgang schichtweise profiliert werden. Im Bereich eines zwischen zwei zueinander benachbarten Schichten zu bildenden Rücksprungs weist die näher an der an die Ausnehmung angrenzenden Oberfläche des Schichtstapels befindliche erste der beiden zueinander benachbarten Schichten eine kleinere Ätzrate auf, als die benachbart dazu angeordnete, weiter von der Oberfläche des Schichtstapels beabstandete zweite Schicht. Dadurch wird im Bereich der zweiten Schicht eine den Rücksprung bildende Unterätzung der ersten Schicht erreicht.

Bei einer besonders vorteilhaften Weiterbildung der Erfindung ist vorgesehen, daß wenigstens eine, insbesondere mehrere elektrisch leitfähige Schichten zu dem Schichtstapel geschichtet werden, daß die Ausnehmung derart in den Schichtstapel eingebracht wird, daß sie insbesondere im Bereich eines Vorsprungs und/oder Rücksprungs der Profilierung der Begrenzungswand an die elektrisch leitfähige(n) Schicht(en) angrenzt, und daß zur Bildung eines Anschlußkontaktes ein elektrisch leitfähiges Bump-Material in die Ausnehmung eingefüllt oder eingebracht wird. Der Bump kann also mit mehreren elektrisch leitfähigen Schichten des Schichtstapels gleichzeitig verbunden sein, die gegebenenfalls ihrerseits untereinander verbunden sein können. Der elektrische Kontaktwiderstand zwischen den elektrisch leitfähigen Schichten und dem Bump wird dadurch erheblich vermindert. Gegebenenfalls kann zusätzlich zu seitlich an die Ausnehmung angrenzenden Schichten des Schichtstapels auch eine den Grund der Ausnehmung bildende Schichtstapel-Schicht aus einem elektrisch leitfähigen Material bestehen, was einen noch geringeren elektrischen Kontaktwiderstand zwischen dem Bump und den elektrisch leitfähigen Schichten ermöglicht. Bei einem Stromfluß in den Bump ergibt sich dann aufgrund des reduzierten ohmschen Übergangswiderstandes zwischen den elektrisch leitfähigen Schichten und dem Bump eine geringere Wärmeentwicklung. Die thermische Belastung der Schaltungsanordnung, die beispielsweise eine integrierte Schaltung aufweisen kann und/oder Teil einer elektrischen Leiterplatte sein kann, wird dadurch entsprechend vermindert. Gegebenenfalls kann der Bump auch als Durchkontaktierung dienen, die in einer und/oder in mehreren unterschiedlichen Schichten des Schichtstapels angeordnete, elektrisch leitfähige Schichtbereiche, wie Leiterbahnen oder dergleichen elektrisch miteinander verbindet. Die elektrisch leitfähigen Schichten des Schichtstapels und/oder das Bump-Material weist vorzugsweise ein oder mehrere Metalle als Hauptbestandteile auf, insbesondere Aluminium, Kupfer, Silber, Gold, Wolfram, Titan, Nickel und/oder Palladium.

Bei einer Ausführungsform der Erfindung ist vorgesehen, daß vor, während und/oder nach dem Einbringen des flüssigen oder fließfähigen Bump-Materials in die Ausnehmung ein insbesondere elektrisch leitfähiger Kontaktstift oder ein Kontaktdraht in das Bump-Material eingesteckt wird und daß das Bump-Material danach verfestigt wird. Dadurch ergibt sich eine einfach herzustellende Bond-Verbindung, die außer einer guten mechanischen Stabilität und einem niedrigen elektrischen Kontaktwiderstand auch den Vorteil hat, daß sie sich nur über einen relativ kleinen Oberflächenbereich des Schichtstapels erstreckt. Bei einer als Halbleiterchip ausgebildeten Schichtanordnung kann dadurch teure Chipfläche eingespart werden.

Vorteilhaft ist, wenn die Ausnehmung als Sackloch in den Schichtstapel eingebracht wird, wenn im Boden der Ausnehmung wenigstens ein dem Inneren der Ausnehmung zugewandtes optisches Sende- und/oder Empfängerelement angeordnet wird und wenn in die Ausnehmung ein optisch transparentes Bump-Material eingefüllt oder eingebracht wird. Dadurch ergibt sich eine kompakt aufgebaute optische Sende- und oder Empfangseinrichtung. Dabei ist es sogar möglich, daß in den Schichtstapel eine Vielzahl von Ausnehmungen arrayförmig nebeneinander eingebracht wird, in denen jeweils zumindest ein optisches Sende- und/oder Empfängerelement angeordnet wird. In unterschiedlichen Ausnehmungen können gegebenenfalls Bump-Materialien unterschiedlicher Farbe, die z.B. Basisfarben eines Farbsystems sein können, als optischer Farbfilter eingefüllt werden.

Bei einer vorteilhaften Ausführungsform des Verfahrens wird wenigstens eine optisch transparente Schicht zu dem Schichtstapel geschichtet und in die Ausnehmung wird ein optisch transparentes Bump-Material eingefüllt oder eingebracht. Die optisch transparente Schicht der nach dem Verfahren hergestellten Schichtanordnung kann dann als Lichtleiter für durch den Bump in den Schichtstapel ein- und/oder aus diesem auszukoppelnde optische Strahlung dienen.

Bezüglich der Schichtanordnung besteht die Lösung der vorstehend genannten Aufgabe darin, daß sich die Ausnehmung quer zu den Schichtungsebenen der Schichten über mehrere Schichten des Schichtstapels erstreckt, daß die seitliche Begrenzungswand der Ausnehmung wenigstens eine Profilierung aufweist, die ausgehend von der an die Ausnehmung angrenzenden Oberfläche des Schichtstapels zum Inneren der Ausnehmung hin schichtweise wenigstens zwei Rücksprünge und zumindest einen dazwischen befindlichen Vorsprung aufweist, und daß der Bump diese Rücksprünge hintergreift.

Der Bump ist dann formschlüssig mit dem Schichtstapel verbunden und hintergreift dessen Schichten bereichsweise, wodurch eine besonders gute Haftung des Bumps an dem Schichtstapel erreicht wird. Darüber hinaus weist die Schichtanordnung eine gute Feuchtigkeits- und Korrosionsbeständigkeit auf. Insbesondere wird durch die Profilierung der seitlichen Begrenzungswand der Ausnehmung und die quer zur Erstreckungsrichtung des Bumps verlaufenden Vorsprünge beziehungsweise Rücksprünge dieser Profilierung der entlang der Begrenzungswand von der Oberfläche des Schichtstapels zu der Rückseite des Bumps beziehungsweise zum Grund der Ausnehmung hin verlaufende Weg vergrößert, so daß an der Oberfläche des Schichtstapels befindliche Feuchtigkeit nicht so leicht zur Rückseite des Bumps gelangen kann. Im übrigen gelten die zu dem Verfahren genannten Vorteile für die Schichtanordnung entsprechend.

Bei einer besonders vorteilhaften Ausführungsform der Erfindung ist der Bump als elektrischer Anschlußkontakt ausgebildet und besteht aus einem elektrisch leitfähigen Material, wobei der Bump mit wenigstens einer, die Ausnehmung des Schichtstapels begrenzenden, vorzugsweise einen Vorsprung der Profilierung der seitlichen Begrenzungswand bildenden Schicht des Schichtstapels elektrisch leitfähig verbunden ist. Dabei ist es sogar möglich, daß mehrere Schichten des Schichtstapels aus einem elektrisch leitfähigen Material bestehen, das mit seinem an die Ausnehmung angrenzenden Randbereich elektrisch leitfähig mit dem Bump verbunden ist. Die Schichtanordnung weist dann einen besonders niedrigen Ohmschen Widerstand zwischen dem Bump und den elektrisch leitfähigen Schichten, die gegebenenfalls untereinander verbunden sein können, auf.

Nachfolgend sind Ausführungsbeispiele der Erfindung anhand der Zeichnung näher erläutert. Es zeigen:
- Fig.1: einen Längsschnitt durch eine mikromechanische Schichtanordnung, mit einer in die Oberfläche eines Schichtstapels eingelassenen Ausnehmung, in der ein Bump für eine Flip-Chip-Verbindung angeordnet ist,
- Fig.2: eine Darstellung ähnlich Fig.1, wobei jedoch in das Bump-Material ein Kontaktstift eingelassen ist und
- Fig.3: eine Darstellung ähnlich Fig.2, wobei jedoch der in das Bump-Material eingreifende Endbereich des Kontaktstifts profiliert ist.

Bei einem Verfahren zum Herstellen einer im ganzen mit 1 bezeichneten Schichtanordnung werden auf einem Substratmaterial 2, das beispielsweise aus Silizium, Galliumarsenid, Siliziumkarbid, Indiumphospid oder dergleichen Festkörpermaterial bestehen kann, mehrere Schichten 3, 4, 5, 6, 7 aus Festkörpermaterial zu einem Schichtstapel 8 geschichtet. Die einzelnen Schichten 3, 4, 5, 6, 7 werden mit aus der Planartechnik an sich bekannten Verfahren, zum Beispiel durch Sputtern oder chemical Vapour deposition (CVD), planar auf das Substratmaterial 2 aufgebracht.

Nach Fertigstellung des Schichtstapels 8 wird mittels eines Ätzmittels in die flachseitige Oberfläche 9 des Schichtstapels 8 quer zu den Schichtungsebenen der Schichten 3, 4, 5, 6, 7 eine von den Schichten 3, 4, 5, 6, 7 seitlich umgrenzte Ausnehmung 10 eingebracht, die mehrere der Schichten 3, 4, 5, 6, 7 durchsetzt und an ihrer tiefsten Stelle an eine Basis-Schicht 11 angrenzt, die in das Substratmaterial 2 eingelassen ist. An der seitlichen Begrenzungswand der Ausnehmung 10 wird durch Abtragen von Schichtmaterial unterschiedlicher Schichten 3, 4, 5, 6, 7 des Schichtstapels 8 eine Profilierung erzeugt, die ausgehend von der Oberfläche 9 des Schichtstapels 8 zum Inneren der Ausnehmung 10 hin schichtweise zwei Rücksprünge 12 und einen dazwischen befindlichen Vorsprung 13 aufweist.

Nach dem Fertigstellen der Profilierung wird ein flüssiges oder fließfähiges Bump-Material 14, das beispielsweise ein Polymer oder ein lötfähiges Metall sein kann, in die Ausnehmung 10 eingefüllt, derart, daß es die Rücksprünge 12 hintergreift. Anschließend wird das Bump-Material 14 verfestigt. Bei einem Polymer kann dies beispielsweise durch Aushärten, bei einem in einem Lösungsmittel gelösten Bump-Material durch Verdunsten des Lösungsmittels und bei einem Metall durch Abkühlen und Erstarren erreicht werden. Nach dem Verfestigen des Bump-Materials ergibt sich zwischen dem Schichtstapel 8 und dem Bump-Material 14 eine formschlüssige Verbindung, die eine hohe mechanische Festigkeit gegen Herauslösen des Bump-Materials 1 4 aus der Ausnehmung 1 0 aufweist. Die Ausnehmung 10 wird in einem Arbeitsgang vollständig mit dem Bump-Material 14 gefüllt. Nach dem Verfestigen des Bump-Materials ist dieses deshalb durchgehend einstückig und unter Vermeidung von Grenzschichten miteinander verbunden.

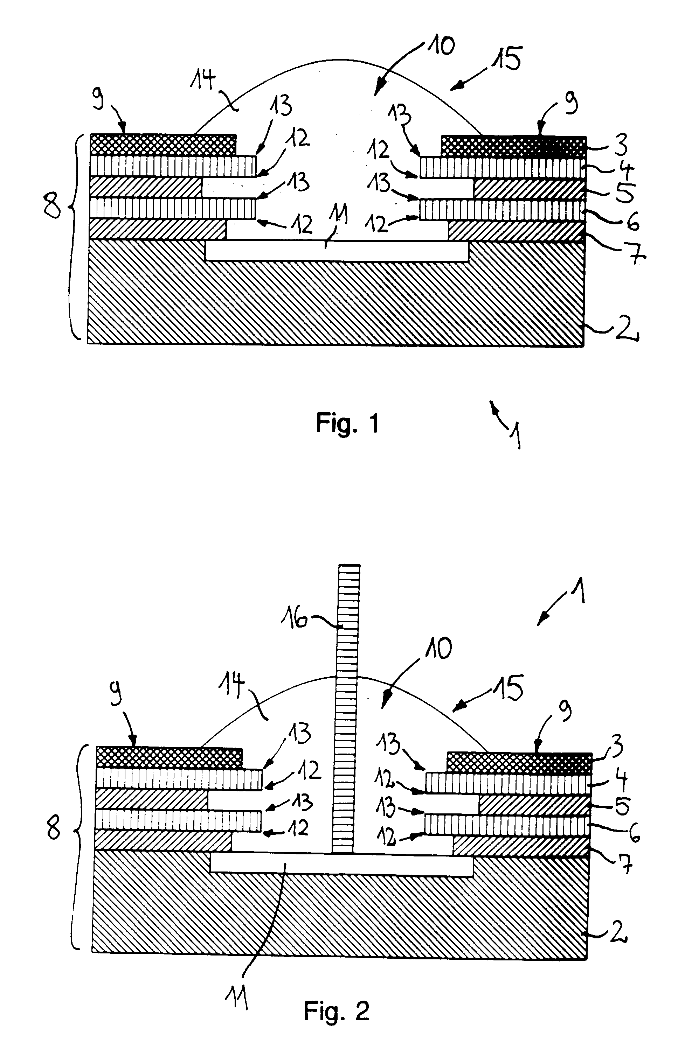

Das Bump-Material 14 wird derart in die Ausnehmung 10 eingefüllt, daß es zumindest nach dem Verfestigen einen gegenüber der durch den Umfangsrand des Bumps aufgespannten Ebene etwa in Erstreckungsrichtung des Bumps vorstehenden Überstand 15 aufweist. Bei den in Fig.1 bis 3 gezeigten Ausführungsbeispielen steht der Überstand 15 jeweils über die Oberfläche 9 des Schichtstapels 8 über. Der Überstand 15 kann aber auch ganz oder teilweise im Inneren der Ausnehmung 10 angeordnet sein. Die quer zu den Schichtungsebenen der Schichten 3, 4, 5, 6, 7 orientierte Dicke des Überstands 14 beträgt ein Vielfaches der entsprechenden Dicke der einzelnen Schichten 3, 4, 5, 6, 7. Der Überstand 15 kann mit einem in der Zeichnug nicht dargestellten Verbindungsteil, beispielsweise einem Chip, einer Leiterplatte oder einem mikromechanischen Bauteil verbunden werden, beispielsweise durch Kleben oder Löten.

Der Rücksprung 12 und der Vorsprung 13 werden durch Ätzen in die Begrenzungswand der Ausnehmung 10 eingebracht. Zueinander benachbart aneinander angrenzende Schichten 3, 5, 6, 7 des Schichtstapels 8 weisen dazu bezüglich des Ätzmittels jeweils eine unterschiedliche Ätzrate auf. In der Zeichnung ist deutlich erkennbar, daß die Schichten 4 und 6 etwa die gleiche Ätzrate aufweisen und daß die dazu benachbarten Schichten 3, 5 und 7 eine größere Ätzrate haben als die Schichten 4 und 6. Dementsprechend weist die Ausnehmung 10 im Bereich der Schichten 3, 5, 6 einen größeren Durchmesser auf als im Bereich der Schichten 4 und 6.

Die Schichten 4, 5, 6, 7 und die Basis-Schicht 11 bestehen aus einem elektrisch leitfähigen, metallischem Material. Der in die Ausnehmung 10 eingreifende Bump ist als elektrischer Anschlußkontakt ausgebildet und besteht ebenfalls aus einem elektrisch leitfähigen Material, beispielsweise aus Metall oder einem Metallpartikel enthaltenden Polymer-Material. Die an die Oberfläche 9 des Schichtstapels 8 angrenzende Schicht 3 ist eine elektrisch isolierende Passivierungsschicht. Die Schichten 4, 5, 6, 7 sind jeweils an der seitlichen Begrenzungswand der Ausnehmung 10 und die Basis-Schicht 11 ist am Grund der Ausnehmung 10 elektrisch leitfähig mit dem Bump-Material 14 verbunden. Außerdem sind die Schichten 4, 5, 6, 7 und 11 untereinander elektrisch leitend verbunden. In vorteilhafter Weise ergibt sich dadurch ein vergleichsweise kleiner elektrischer Kontaktwiderstand zwischen dem Bump-Material 14 und den Schichten 4, 5, 6, 7, 11 des Schichtstapels 8. In der Zeichnung ist deutlich erkennbar, daß durch die Rücksprünge 12 und die Vorsprünge 13 eine relativ große Verbindungsfläche zwischen dem Bump-Material 14 und dem Schichtstapel 8 vorhanden ist, wodurch der elektrische Widerstand zwischen dem Bump-Material und den elektrisch leitfähigen Schichten 4, 5, 6, 7, 11 des Schichtstapels 8 zusätzlich vermindert wird. Entsprechend ergibt sich auch eine gute Wärmeleitfähigkeit zwischen dem Bump-Material und den Schichtstapel 8, wodurch die thermische Beanspruchung der Schichtanordnung 1 reduziert wird.

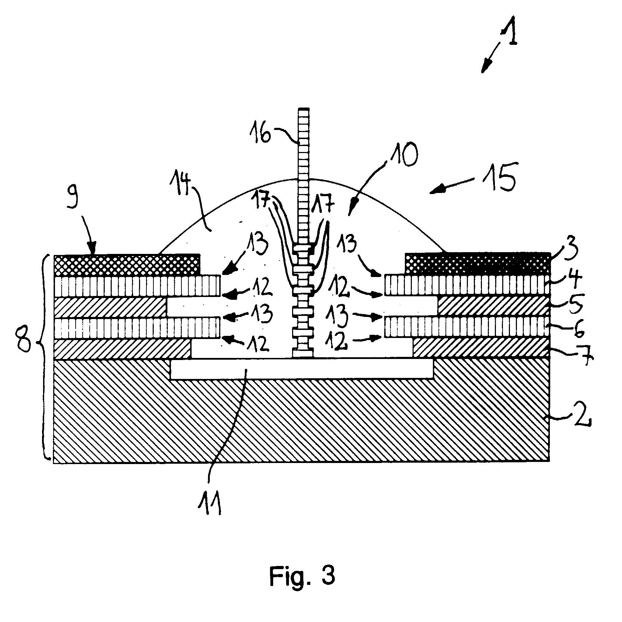

Bei dem Ausführungsbeispiel nach Fig.2 wird vor dem Verfestigen des in die Ausnehmung 10 eingebrachten Bump-Materials ein Kontaktstift 16 in das Bump-Material 14 eingesetzt, der beispielsweise ein zu einem externen Anschlußpad führender Bonddraht sein kann. Aus Fig.2 ist erkennbar, daß der Kontaktstift 16 mit seiner Längsachse quer, insbesondere etwa orthogonal zu den Schichtungsebenen der Schichten 3, 4, 5, 6, 7 angeordnet ist. Die Bondverbindung beansprucht deshalb nur einen relativ kleinen Teilbereich der Oberfläche 9 des Schichtstapels 8. Zum Verankern des Kontaktstift 16 in dem Bump-Material 14 kann der Kontaktstift 16 quer zu seiner Erstreckungsrichtung orientierte Profilierungsvorsprünge 17 aufweisen, welche das Bump-Material 14 in Gebrauchsstellung jeweils hintergreift (Fig. 3). Die Vorsprünge 17 sind zumindest an einem in das Bump-Material eingreifenden Abschnitt des Kontaktstifts 16 vorgesehen, können aber auch in einem außerhalb des Bump-Materials 14 befindlichen Kontaktstift-Abschnitt angeordnet sein.

Erwähnt werden soll noch, daß der Schichtstapel 8 insbesondere zwischen zwei elektrisch leitfähigen Schichten 2, 3, 4, 5, 6, 7, 11 wenigstens eine elektrische Isolationsschicht aufweisen kann, die zum Beispiel aus Siliziumoxyd, Siliziumnitrid oder SIPOS bestehen kann. Bei dem Ausführungsbeispiel nach Fig.1 kann können beispielsweise die Schichten 5, 7 Isolationsschichten sein. Solche Isolationsschichten sind vor allem bei einem mittels eines CMOS-Prozeß hergestellten CMOS-Bauteil von Vorteil, bei dem für die Funktion des CMOS-Bauteils benötigte Leiterbahnen durch ganzflächiges Aufbringen einer Metallisierung auf einen Chip und anschließendes Maskieren dieser Metallisierung hergestellt werden, wobei zwischen zueinander benachbarten Schichten mit Leiterbahnen jeweils eine Isolationsschicht angeordnet wird. Die an die Ausnehmung 10 seitlich angrenzenden Schichten 3, 4, 5, 6, 7 des Schichtstapels 8 können dann beim Maskieren der Metallisierung in einem Arbeitsgang mit den Leiterbahnen hergestellt werden. In vorteilhafter Weise kann dadurch das Aufbringen zusätzlicher Schichten 3, 4, 5, 6, 7 für den Schichtstapel 8 entfallen.

Zusammenfassend werden somit bei einem Verfahren zum Herstellen einer einen Bump für eine Flip-Chip- oder dergleichen Verbindung aufweisenden Schichtanordnung 1 mehrere Schichten 2, 3, 4, 5, 6, 7, 11 aus Festkörpermaterial zu einem Schichtstapel 8 geschichtet. In den Schichtstapel 8 wird quer zu den Schichtungsebenen der Schichten 2, 3, 4, 5, 6, 7, 11 eine sich über mehrere der Schichten 2, 3, 4, 5, 6, 7, 11 erstreckende Ausnehmung 10 eingebracht. In die Ausnehmung 10 wird ein Bump-Material 14 eingebracht. An der seitlichen Begrenzungswand der Ausnehmung 10 durch Abtragen von Schichtmaterial unterschiedlicher Schichten 2, 3, 4, 5, 6, 7, 11 des Schichtstapels 8 eine Profilierung erzeugt wird, die ausgehend von der Oberfläche 9 des Schichtstapels 8 zum Inneren der Ausnehmung 10 hin schichtweise wenigstens zwei Rücksprünge 12 und zumindest einen dazwischen befindlichen Vorsprung 13 aufweist. Nach dem Fertigstellen der Profilierung wird ein Bump-Material 14 in die Ausnehmung 10 eingebracht, das die Rücksprünge 12 hintergreift.

## Patentansprüche

1. Verfahren zum Herstellen einer wenigstens einen Bump aufweisenden Schichtanordnung (1), insbesondere für eine Flip-Chip- oder dergleichen Verbindung, wobei mehrere Schichten (2, 3, 4, 5, 6, 7, 11) aus Festkörpermaterial zu einem Schichtstapel (8) geschichtet werden, in den quer zu den Schichtungsebenen der Schichten (2, 3, 4, 5, 6, 7, 11) wenigstens eine Ausnehmung (10) eingebracht wird, in die ein Bump-Material (14) eingefüllt oder eingebracht wird, **dadurch gekennzeichnet**, daß in den Schichtstapel (8) eine sich über mehrere seiner Schichten (2, 3, 4, 5, 6, 7, 11) erstreckende Ausnehmung (10) eingebracht wird, daß an der seitlichen Begrenzungswand der Ausnehmung (10) durch Abtragen von Schichtmaterial unterschiedlicher Schichten (2, 3, 4, 5, 6, 7, 11) des Schichtstapels (8) eine Profilierung erzeugt wird, die ausgehend von der an die Ausnehmung (10) angrenzenden Oberfläche (9) des Schichtstapels (8) zum Inneren der Ausnehmung (10) hin schichtweise wenigstens zwei Rücksprünge (12) und zumindest einen dazwischen befindlichen Vorsprung (13) aufweist und daß das Bump-Material (14) nach dem Fertigstellen der Profilierung derart in die Ausnehmung (10) eingebracht wird, daß es die Rücksprünge (12) hintergreift.

2. Verfahren nach Anspruch 1, dadurch gekennzeichnet, daß ein flüssiges oder fließfähiges Bump-Material (14) in die Ausnehmung (10) eingebracht und anschließend verfestigt wird, insbesondere durch Erstarren, Aushärten, und/oder durch Trocknen eines in dem Bump-Material (14) enthaltenen Lösungsmittels.

3. Verfahren nach Anspruch 1 oder 2, dadurch gekennzeichnet, daß das Bump-Material (14) auf die seitliche Begrenzungswand und/oder den Boden der Ausnehmung (10) aufgalvanisiert wird.

4. Verfahren nach einem der Ansprüche 1 bis 3, dadurch gekennzeichnet, daß der Schichtstapel (8) zum Einbringen der Ausnehmung (10) mit einem Ätzmittel in Berührung gebracht wird und daß die Schichtmaterialien der einzelnen Schichten (2, 3, 4, 5, 6, 7, 11) zum Einformen der Profilierung in die Begrenzungswand der Ausnehmung (10) so ausgewählt werden, daß sie bezüglich des Ätzmittels unterschiedliche Ätzraten aufweisen.

5. Verfahren nach einem der Ansprüche 1 bis 4, dadurch gekennzeichnet, daß wenigstens eine, insbesondere mehrere elektrisch leitfähige Schichten (2, 3, 4, 5, 6, 7, 11) zu dem Schichtstapel (8) geschichtet werden, daß die Ausnehmung (10) derart in den Schichtstapel (8) eingebracht wird, daß sie insbesondere im Bereich eines Vorsprungs (12) und/oder Rücksprungs (13) der Profilierung der Begrenzungswand an die elektrisch leitfähige(n) Schicht(en) (2, 3, 4, 5, 6, 7, 11) angrenzt, und daß zur Bildung eines Anschlußkontaktes ein elektrisch leitfähiges Bump-Material (14) in die Ausnehmung (10) eingefüllt oder eingebracht wird.

6. Verfahren nach einem der Ansprüche 1 bis 5, dadurch gekennzeichnet, daß vor, während und/oder nach dem Einbringen des flüssigen oder fließfähigen Bump-Materials (14) in die Ausnehmung (10) ein insbesondere elektrisch leitfähiger Kontaktstift (16) oder ein Kontaktdraht in das Bump-Material (14) eingesteckt wird und daß das Bump-Material (14) danach verfestigt wird.

7. Verfahren nach einem der Ansprüche 1 bis 6, dadurch gekennzeichnet, daß die Ausnehmung (10) als Sackloch in den Schichtstapel (8) eingebracht wird, daß im Boden der Ausnehmung wenigstens ein dem Inneren der Ausnehmung (10) zugewandtes optisches Sende- und/oder Empfängerelement angeordnet wird und daß in die Ausnehmung (10) ein optisch transparentes Bump-Material (14) eingefüllt oder eingebracht wird.

8. Verfahren nach einem der Ansprüche 1 bis 7, dadurch gekennzeichnet, daß wenigstens eine optisch transparente Schicht (2, 3, 4, 5, 6, 7, 11) zu dem Schichtstapel (8) geschichtet wird und daß die Ausnehmung (10) ein optisch transparentes Bump-Material (14) eingefüllt oder eingebracht wird.

9. Schichtanordnung (1) mit einem mehrere Schichten (2, 3, 4, 5, 6, 7, 11) aus Festkörpermaterial aufweisenden Schichtstapel (8), der eine sich quer zu den Schichtungsebenen der Schichten (2, 3, 4, 5, 6, 7, 11) erstreckende Ausnehmung (10) hat, in der ein insbesondere für eine Flip-Chip- oder dergleichen Verbindung vorgesehener Bump angeordnet ist, der aus einem durchgehend einstückigen Bump-Material (14) besteht, **dadurch gekennzeichnet**, daß sich die Ausnehmung (10) quer zu den Schichtungsebenen der Schichten (2, 3, 4, 5, 6, 7, 11) über mehrere Schichten (2, 3, 4, 5, 6, 7, 11) des Schichtstapels (8) erstreckt, daß die seitliche Begrenzungswand der Ausnehmung (10) wenigstens eine Profilierung aufweist, die ausgehend von der an die Ausnehmung (10) angrenzenden Oberfläche (9) des Schichtstapels (8) zum Inneren der Ausnehmung (10) hin schichtweise wenigstens zwei Rücksprünge (12) und zumindest einen dazwischen befindlichen Vorsprung (13) aufweist, und daß der Bump diese Rücksprünge (12) hintergreift.

10. Schichtanordnung nach Anspruch 9, dadurch gekennzeichnet, daß der Bump durch eine in die Ausnehmung (10) eingefüllte Vergußmasse gebildet ist.

11. Schichtanordnung nach Anspruch 9 oder 10, dadurch gekennzeichnet, daß das Bump-Material auf die seitliche Begrenzungswand der Ausnehmung (10) und/oder den Boden der Ausnehmung (10) aufgalvanisiert ist.

12. Schichtanordnung nach einem der Ansprüche 9 bis 11, dadurch gekennzeichnet, daß die die Profilierung aufweisende Ausnehmung (10) in den Schichtstapel (8) eingeätzt ist.

13. Schichtanordnung nach einem der Ansprüche 9 bis 12, dadurch gekennzeichnet, daß der Bump als elektrischer Anschlußkontakt ausgebildet ist und aus einem elektrisch leitfähigen Bump-Material (14) besteht, und daß der Bump mit wenigstens einer, die Ausnehmung (10) des Schichtstapels (8) begrenzenden, vorzugsweise einen Rücksprung (12) und/oder einen Vorsprung (13) der Profilierung der seitlichen Begrenzungswand aufweisenden Schicht (2, 3, 4, 5, 6, 7, 11) des Schichtstapels (8) elektrisch leitfähig verbunden ist.

14. Schichtanordnung nach einem der Ansprüche 9 bis 13, dadurch gekennzeichnet, daß in den Bump ein insbesondere elektrisch leitfähiger Kontaktstift (16) oder ein Kontaktdraht eingesetzt ist.

15. Schichtanordnung nach einem der Ansprüche 9 bis 14, dadurch gekennzeichnet, daß der Bump aus einem optisch transparenten Bump-Material (14) besteht und insbesondere an seinem freien Ende einen etwa linsenförmigen Überstand (15) aufweist, daß die Ausnehmung (10) als Sackloch ausgebildet ist und daß im Boden der Ausnehmung (10) wenigstens ein dem Bump zugewandtes optisches Sende- und/oder Empfängerelement angeordnet ist.

16. Schichtanordnung nach einem der Ansprüche 9 bis 15, dadurch gekennzeichnet, daß der Bump und zumindest eine Schicht (2, 3, 4, 5, 6, 7, 11) des Schichtstapels (8) aus einem optisch transparenten Material bestehen.
